# EUROPEAN PATENT APPLICATION

(11) **EP 4 117 033 A1**
(43) Date of publication of application: **11.01.2023**
(21) Application number: 22180775.3
(22) Date of filing: 23.06.2022
(51) Int. Cl.: H01L 25/075, H01L 33/62

(54) **ULTRAVIOLET LIGHT IRRADIATION DEVICE AND EXPOSURE SYSTEM**

(30) Priority: 05.07.2021 JP 2021111298
(71) Applicant: Ushio Denki Kabushiki Kaisha, Tokyo 100-8150 (JP)
(72) Inventor: Omae, Yasushi, Tokyo, 100-8150 (JP)
(74) Representative: Tomerius, Isabel

(57) **Abstract**

An ultraviolet light irradiation device (100) includes a substrate (1), a plurality of current-carrying areas (2) formed on the substrate (1), and a plurality of ultraviolet light-emitting elements (3) arranged in each of the current-carrying areas (2). The plurality of current-carrying areas (2) are arranged such that their edges (20) are adjacent each other with an insulation distance apart. Each of the ultraviolet light-emitting elements (3) is arranged on a side of the current-carrying area (2), the side being closer to an adjacent current-carrying area (2) connected to the current-carrying area (2) via a wire. A first electrode (31) formed on a back surface of each of the ultraviolet light-emitting elements (3) is in contact with the current-carrying area (2). A second electrode (32) formed on a front surface of each of the ultraviolet light-emitting elements (3) is connected to the adjacent current-carrying area (2) via the wire.

## Description

### CROSS-REFERENCE TO RELATED APPLICATION(S)

This application claims priority from Japanese Patent Application No. 2021-111298. The entire teachings of the above application are incorporated herein by reference.

### TECHNICAL FIELD

The present invention relates to an ultraviolet light irradiation device and an exposure system.

### BACKGROUND ART

Optical application systems using light-emitting elements (typically LED elements) have been widely commercialized. Examples of the optical application systems include exposure systems, ultraviolet curing systems (UV curing), and fixing systems (curing and fixing of UV-curable inks). In these optical application systems, light-emitting elements that emit ultraviolet light (hereinafter referred to as "ultraviolet light-emitting elements") are used. The term "light-emitting element" here refers to a so-called "solid-state light source element" and is used to distinguish it from a discharge lamp.

In light-emitting elements, light output and luminous efficiency are susceptible to temperature variations, thus requiring a more efficient and stable cooling on the light-emitting elements. In addition, although a larger current flowing through the light-emitting element makes its luminous brightness higher, at the same time, its luminous efficiency decreases due to the increase of the amount of heat generated. Hence, cooling the light-emitting element while allowing a large current to flow through it is a key to achieving a high brightness of the light-emitting element.

Incidentally, with the recent development of the light-emitting elements, their luminous brightness itself has been increasing every year; however their luminous brightness is still small compared to that of conventional light sources such as discharge lamps. Hence, optical application systems typically use a large number of light-emitting elements arranged on a substrate.

For example, Patent Document 1 discloses a configuration in which a plurality of light-emitting elements are arranged on a first plane, and light emitted from each light-emitting element is guided in a predetermined direction.

In the case of using the plurality of light-emitting elements as described above, it is necessary to devise a power-feeding structure for each light-emitting element. For example, a power-feeding structure in which the plurality of light-emitting elements are connected in series-parallel is beneficial to achieve high output power of the light source while preventing the overload of the light-emitting elements or disconnection. If all of the light-emitting elements are connected in series, the voltage necessary for lighting them will be higher; however, the power-feeding structure of the series-parallel connection eliminates the need to apply a higher voltage than the structure in which all of the light-emitting elements are connected in series. In addition, in the structure in which all of the light-emitting elements are connected in series, a disconnection occurring in the middle of the series connection fails to supply a current to all of the light-emitting elements. In contrast, in the power-feeding structure of series-parallel connection, a disconnection occurring in a part of the series connection avoids interrupting the power supply to all of the light-emitting elements.

For example, Patent Document 2 discloses a power-feeding structure of series-parallel connection in which a plurality of strip-shaped wirings are arranged in parallel, each strip-shaped wiring having a plurality of LED elements thereon, and each LED element being electrically connected to the adjacent strip-shaped wiring.
Patent Document 1: Japanese Patent 6471900
Patent Document 2: JP-A-2014-027214

### SUMMARY OF THE INVENTION

In recent years, a demand of increasing the luminous intensity of light-emitting elements has been requesting a power-feeding structure that can achieve higher output power of the light source while suppressing the overload to the light-emitting elements and disconnection. In addition, arrangement patterns of light-emitting elements vary depending on the application, and are necessary to maintain a series-parallel circuit structure while applying it to a variety of LED arrangement patterns. In such cases, it is undesirable for wiring paths to become complex.

In view of the above issues, it is an object of the present invention that provides an ultraviolet light irradiation device having a power-feeding structure that is improved over conventional one for ultraviolet light-emitting elements. It is also an object of the present invention that provides an exposure system that is provided with the ultraviolet light irradiation device.

An ultraviolet light irradiation device according to the present invention includes:
a substrate;
a plurality of current-carrying areas formed on the substrate; and
a plurality of ultraviolet light-emitting elements arranged in each of the current-carrying areas,
wherein the plurality of current-carrying areas are arranged such that their edges are adjacent each other with an insulation distance apart,
each of the ultraviolet light-emitting elements is arranged on a side of the current-carrying area, the side being closer to an adjacent current-carrying area connected to the current-carrying area via a wire,
a first electrode formed on a back surface of each of the ultraviolet light-emitting elements is in contact with the current-carrying area, and
a second electrode formed on a front surface of each of the ultraviolet light-emitting elements is connected to the adjacent current-carrying area via the wire.

The present invention provides the ultraviolet light irradiation device that enables high output power, while suppressing the overload to the plurality of ultraviolet light-emitting elements and disconnection, because of the series-parallel connection of the ultraviolet light-emitting elements.

In the above, the "front surface of the ultraviolet light-emitting element" refers to its light-extraction surface of the ultraviolet light-emitting element, i.e., the surface opposite to the surface facing the substrate. The "back surface of the ultraviolet light-emitting element" refers to a surface of the ultraviolet light-emitting element opposite to the light-extraction surface, i.e., the surface facing the substrate.

In the above, the "electrode" is a concept that encompasses a point in which a current is supplied from outside the element or a current flows out toward outside the element; in this sense, the electrode includes a conductive substrate. More specifically, in the case of a light-emitting element in which a semiconductor layer is stacked on a top layer of a conductive substrate, a top electrode is disposed on the light-extraction surface of the semiconductor layer, and applying a voltage between both ends of the top electrode and the conductive substrate supplies a current to the semiconductor layer to emit light; the top electrode and the conductive substrate each correspond to an "electrode" in the present specification. In this case, a wire is connected to the top electrode. Typically, the semiconductor layer includes a p-type semiconductor layer, an active layer, and an n-type semiconductor layer stacked in sequence from the side closer to the conductive substrate. In this case, a current flows from the conductive substrate to the top electrode formed on the top surface of the n-type semiconductor layer. However, the positions of the p-type semiconductor layer and n-type semiconductor layer may be switched.

The ultraviolet light irradiation device according to the present invention may be configured such that each of the edges is formed in a zigzag shape and includes a plurality of first straight line sections, a plurality of second straight line sections extending in a direction intersecting the plurality of first straight line sections, and a plurality of bent sections each connecting the first straight line section and the second straight line section; and the ultraviolet light-emitting element is disposed such that one side of the ultraviolet light-emitting element is along the first straight line section or the second straight line section of the edge. This configuration makes it easier to coincide the wiring direction and distance of the wires each connecting the ultraviolet light-emitting element to an adjacent current-carrying area.

The ultraviolet light irradiation device according to the present invention may be configured such that the ultraviolet light-emitting element is disposed in the bent section of the edge. This configuration allows the ultraviolet light-emitting element to be readily disposed at a predetermined position in the current-carrying area.

The scope of "first straight line section" and the "second straight line section" in the above are intended to encompass the case in which a straight line is completely straight, as well as the case in which a fine uneven structure intersecting a straight line is formed on the straight line, and the case in which a fine curved portion that can be recognized as substantially a straight line is formed.

The ultraviolet light irradiation device according to the present invention may be configured such that the plurality of ultraviolet light-emitting elements are presented in a predetermined arrangement pattern and are arranged with approximately equal spacing. This configuration enables the ultraviolet light irradiation device to uniformly emit light.

The ultraviolet light irradiation device according to the present invention may be configured such that the plurality of ultraviolet light-emitting elements are presented in a staggered arrangement pattern on the entire substrate. This configuration enables the ultraviolet light irradiation device to uniformly emit light.

The ultraviolet light irradiation device according to the present invention may be configured such that the plurality of current-carrying areas are electrically connected to each other in a manner that a power-feeding path meanders. This configuration, in which the power-feeding path is configured to meander in a manner to fill the predetermined arrangement pattern of the ultraviolet light-emitting elements, suitably enables the series-parallel connection of the plurality of ultraviolet light-emitting elements that are densely arranged.

The ultraviolet light irradiation device according to the present invention may be configured such that the current-carrying area has its width at least twice as wide as that of the ultraviolet light-emitting element. This configuration is capable of enhancing the cooling characteristics of the ultraviolet light-emitting element while enabling a stable power supply to each ultraviolet light-emitting element.

An exposure system according to the present invention is provided with the above-mentioned ultraviolet light irradiation device and an optical component corresponding to each of the plurality of ultraviolet light-emitting elements arranged in the ultraviolet light irradiation device. In the exposure device, the ultraviolet light-emitting elements are desired to have high brightness. Achieving the ultraviolet light-emitting elements having high brightness involves a large current passing through each of the ultraviolet light-emitting elements, hence a wiring structure of the ultraviolet light-emitting elements described in the present invention is suitable.

### BRIEF DESCRIPTION OF DRAWINGS

FIG. 1 is a front view of an ultraviolet light irradiation device according to the present embodiment.
FIG. 2 is a partially enlarged view of the ultraviolet light irradiation device shown in FIG. 1.
FIG. 3 is a partially enlarged view of the ultraviolet light irradiation device shown in FIG. 2.
FIG. 4 is a cross-sectional view of the ultraviolet light irradiation device taken along the line IV-IV of FIG. 2.
FIG. 5 is a partially enlarged view of the ultraviolet light irradiation device accordingto another embodiment.
FIG. 6 is a partially enlarged view of the ultraviolet light irradiation device accordingto another embodiment.
FIG. 7 is a partially enlarged view of the ultraviolet light irradiation device accordingto another embodiment.

### DETAILED DESCRIPTION OF THE EMBODIMENTS

Hereinafter, embodiments of an ultraviolet light irradiation device according to the present invention will now be described with reference to the drawings. It is noted that each of the following drawings related to the ultraviolet light irradiation device is merely schematically illustrated. The dimensional ratios on the drawings do not necessarily match the actual dimensional ratios; the dimensional ratios on the drawings do not necessarily match the dimensional ratios on the other drawings either.

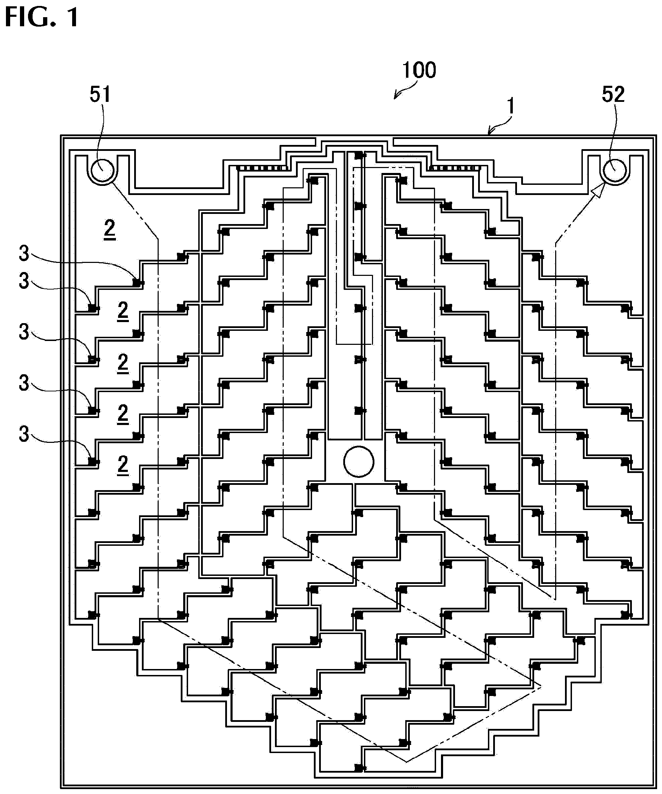

FIG. 1 is a front view illustrating an ultraviolet light irradiation device 100 according to the present invention. The ultraviolet light irradiation device 100 is provided with a substrate 1, a plurality of current-carrying areas 2 formed on the substrate 1, and a plurality of ultraviolet light-emitting elements 3 arranged on each of the current-carrying areas 2.

In the present specification, the surface of the substrate 1 on which the ultraviolet light-emitting elements 3 are mounted is referred to as the "front" surface, and the surface of the substrate 1 opposite to the front surface is referred to as the "back" surface.

The substrate 1 is constituted by a material with high insulation and high thermal conductivity. Examples of the materials constituting the substrate 1 include aluminum nitride and silicon nitride. The substrate 1 has a square or rectangular plate shape from a standpoint of, for example, ease of manufacturing and positioning. The substrate 1 has a thickness of, for example, 0.635 mm.

Current-carrying areas 2 are formed on the front surface of the substrate 1 and includes a wiring pattern. The ultraviolet light-emitting elements 3 are arranged on the current-carrying areas 2. The current-carrying areas 2 are constituted by a material with excellent conductivity. The current-carrying area 2 has a foil-shape made of materials including copper and a copper alloy. The current-carrying area 2 has a thickness of, for example, 0.03 mm. The plurality of current-carrying areas 2 in the present embodiment are formed by bonding the copper foil to the substrate 1 and then etching the bonded object to the desired pattern. The front surface of the current-carrying areas 2 are covered with resist (not shown) except for the area in which the ultraviolet light-emitting elements 3 and wires 4 (to be described later) are mounted.

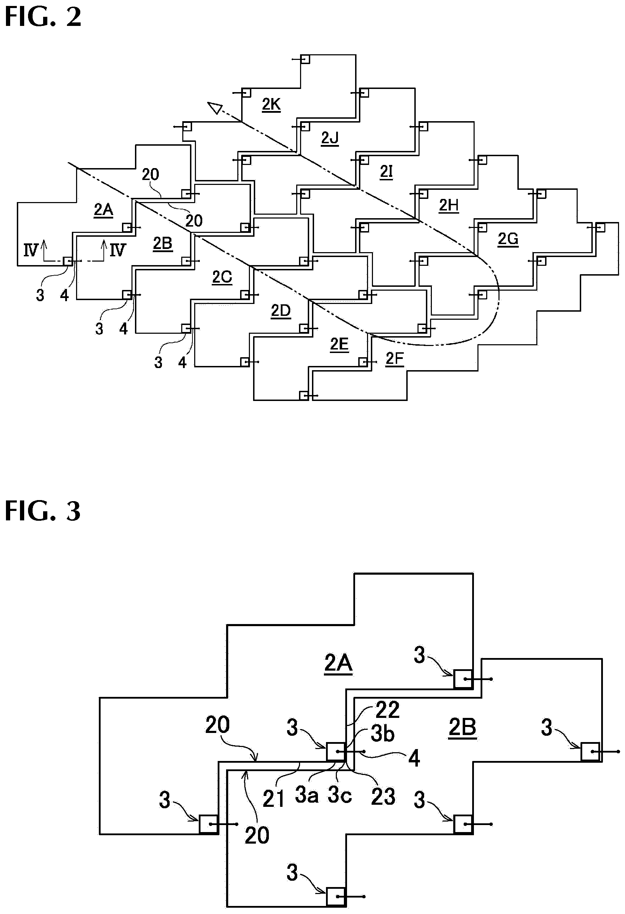

FIG. 2 is an enlarged view of a portion of the ultraviolet light irradiation device 100 shown in FIG. 1. The plurality of current-carrying areas 2 are arranged such that their edges 20 are adjacent each other with an insulation distance apart. The insulation distance between the edges 20 of the adjacent current-carrying areas 2 is approximately constant.

FIG. 2 illustrates eleven current-carrying areas 2A-2K among the plurality of current-carrying areas 2. FIG. 3 illustrates only the current carrying area 2A and the current-carrying area 2B. The edges 20 of the current-carrying areas 2A-2K are each formed in a zigzag shape, and include a plurality of first straight line sections 21, a plurality of second straight line sections 22 extending in a direction intersecting the plurality of first straight line sections 21, and a plurality of bent sections 23 each connecting the first straight line section 21 and the second straight line section 22. In the present embodiment, the first straight line sections 21 are orthogonal to the second straight line sections 22.

The plurality of ultraviolet light-emitting elements 3 are arranged in a predetermined arrangement pattern, and are arranged to form a hexagonal arrangement pattern as a whole, as shown in FIG. 1. The plurality of ultraviolet light-emitting elements 3 are arranged with each other with approximately equal spacing. The plurality of ultraviolet light-emitting elements 3 are arranged in a staggered pattern in the entire substrate 1.

The ultraviolet light-emitting elements 3 are LED elements that emit ultraviolet light. The plurality of ultraviolet light-emitting elements 3 are arranged on each current-carrying area 2.

In the present embodiment, although three ultraviolet light-emitting elements 3 are arranged on each current-carrying area 2, the number of the ultraviolet light-emitting elements 3 is not limited to that of the embodiment. However, from the viewpoint of suppressing illuminance variation in the plane direction, the number of the ultraviolet light-emitting elements 3 arranged on each current-carrying area 2 may preferably be the same.

The ultraviolet light-emitting element 3 is disposed on a side of the current-carrying area 2, the side being closer to an adjacent current-carrying area 2 connected to the current-carrying area via a wire. In other words, the ultraviolet light-emitting element 3 is disposed in the current-carrying area 2 in close proximity to the edge 20. The ultraviolet light-emitting element 3 is disposed such that one side of the ultraviolet light-emitting element 3 is along the first straight line section 21 or the second straight line section 22 of the edge 20. This configuration makes it easier to match the wiring direction and distance of the wires 4 (to be described later) each connecting the ultraviolet light-emitting element 3 to the adjacent current-carrying area 2.

In the present embodiment, as shown in FIG. 3, a first side 3a of the ultraviolet light-emitting element 3 is positioned along the first straight line section 21 of the edge 20, and a second side 3b of the ultraviolet light-emitting element 3 is positioned along the second straight line section 22 of the edge 20. In other words, the ultraviolet light-emitting element 3 is disposed such that a corner 3c constituted by the first side 3a and the second side 3b coincides with a bent section 23 of the edge 20. This configuration allows the ultraviolet light-emitting element 3 to be readily disposed at a predetermined position in the current-carrying area 2.

The current-carrying area 2 of the present embodiment is formed wider than the width of the ultraviolet light-emitting element 3. Typically, the current-carrying area 2 is formed to be as wide as the width of the ultraviolet light-emitting element 3. In contrast, the current-carrying area 2 of the present embodiment is formed to be at least twice as wide as the width of the ultraviolet light-emitting element 3. Here, the width of the current-carrying area 2 refers to the narrowest width thereof, and the width of the ultraviolet light-emitting element 3 refers to the length of one side of its rectangle shape. This configuration is capable of enhancing the cooling characteristics of the ultraviolet light-emitting element 3 while enabling a stable power supply to each ultraviolet light-emitting element 3. The specific reasons for the enhanced cooling characteristics of the ultraviolet light-emitting elements 3 are described as follows. The substrate 1 is provided with a cooling section (not shown) such as a heat sink and a water cooling mechanism on the back surface thereof, thus constitutes a structure such that the heat generated from the ultraviolet light-emitting element 3 is dissipated by the cooling section through the substrate 1. In this structure, the wide formation of the current-carrying area 2 allows heat generated from the ultraviolet light-emitting element 3 to be spread over the current-carrying area 2 and then easily dissipated in the cooling section through the substrate 1, thereby substantially increasing the heat dissipation area.

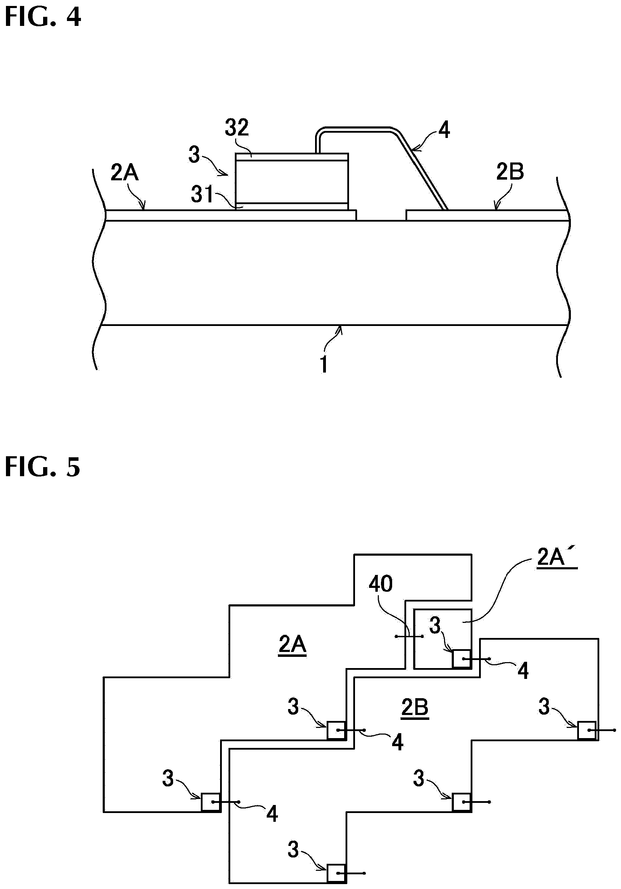

FIG. 4 is a cross-sectional view of the ultraviolet light irradiation device 100 taken along the line IV-IV of FIG. 2. The ultraviolet light-emitting element 3 is provided with a first electrode 31 on the back surface thereof, and a second electrode 32 on the front surface thereof. For example, the first electrode 31 is an anode electrode provided on a p-type semiconductor layer (not shown) of the ultraviolet light-emitting element 3, and the second electrode 32 is a cathode electrode provided on an n-type semiconductor layer (not shown) of the ultraviolet light-emitting element 3. In other words, the ultraviolet light-emitting element 3 has a vertical device structure, in which the current flows from the back surface to the front surface.

The ultraviolet light-emitting element 3 is soldered on the current-carrying area 2 (not shown). The first electrode 31 of the ultraviolet light-emitting element 3 has its entire surface in contact with the current-carrying area 2 (current-carrying area 2A in FIG. 4). As a result, the three ultraviolet light-emitting elements 3 on the current-carrying area 2A are connected in parallel. Similarly, the three ultraviolet light-emitting elements 3 on each current-carrying area 2 are connected in parallel.

Meanwhile, the second electrode 32 of the ultraviolet light-emitting element 3 is connected via the wire 4 to an adjacent current-carrying area 2 (the current-carrying area 2B in FIG. 4). The wire 4 extends from the front surface of the second electrode 32 to the adjacent current-carrying area 2B, the wire being parallel to the first straight line section 21 of the edge 20. As a result, the ultraviolet light-emitting elements 3 on the current-carrying area 2A are connected in series with the ultraviolet light-emitting elements 3 on the current-carrying area 2B. Similarly, the ultraviolet light-emitting element 3 on each current-carrying area 2 is connected in series with the ultraviolet light-emitting element 3 on the adjacent current-carrying area 2. This configuration allows the current to flow through the current-carrying area 2A, current-carrying area 2B, ..., and current-carrying area 2K, in sequence, as shown by the two-dot chain line in FIG. 2.

As shown in FIG. 2, all of the wires 4 extending from the respective ultraviolet light-emitting elements 3 extend in the same direction. This configuration readily enables the wiring of the wires 4. However, all of the wires 4 do not necessarily extend in the same direction.

The ultraviolet light irradiation device 100 is provided with a pair of power-feeding sections 51 and 52 as shown in FIG. 1. The power-feeding sections 51 and 52 are connected to a power supply unit (not shown) that supplies power to the ultraviolet light irradiation device 100. For example, the power-feeding section 51 is on an anode side and the power-feeding section 52 is on a cathode side.

The current supplied by the power supply unit flows from the power-feeding section 51 to the power-feeding section 52 through the current-carrying areas 2, the ultraviolet light-emitting elements 3, and the wires 4. The power-feeding path is shown as a two-dot chain line in FIG. 1. As shown in FIG. 1, the plurality of current-carrying areas 2 are electrically connected to each other in a manner that the power-feeding path meanders. This configuration, in which the power-feeding path is configured to meander in a manner to fill the hexagonal arrangement pattern of the ultraviolet light-emitting elements 3, suitably enables the series-parallel connection of the plurality of ultraviolet light-emitting elements 3 that are densely arranged.

The embodiments of the present invention are described with reference to the drawings; however, the specific configuration is not considered to be limited to these embodiments. The scope of the present invention is represented by the scope of the claims as well as the description of the embodiments above, and also includes all of the modifications within the scope of the claims and the meaning equivalent to the claims.

The structure employed in each of the above embodiments cab be employed in any other embodiment. The specific structure of each component is not limited only to the embodiments described above, and can be variously modified to the extent that it does not depart from the intent of the present invention.

(1) In the above embodiment of the ultraviolet light irradiation device 100, the current flows from the power-feeding section 51 to the power-feeding section 52; however the current is not limited to this embodiment. The current may flow from the power-feeding section 52 to the power-feeding section 51. In other words, the power-feeding section 52 may be the anode side and the power-feeding section 51 may be the cathode side. In this case, the first electrode 31 of the ultraviolet light-emitting element 3 is the cathode side electrode and the second electrode 32 is the anode side electrode, thus the current flows from the front surface to the back surface.

(2) The current-carrying area 2 in the above embodiment is configured to be a single island; however it is not limited to this. The current-carrying area 2 may be configured to be a plurality of islands. For example, as shown in FIG. 5, the current-carrying area 2 includes the current-carrying area 2A and a current-carrying area 2A', which is separated from the current-carrying area 2A. The current-carrying area 2A is connected to the current-carrying area 2A' via the wire 40 and has the potential same as that of the current-carrying area 2A'. Accordingly, the current-carrying area 2 of the present specification includes the area configured to be a plurality of islands having the same potential as well as the area configured to be a single island.

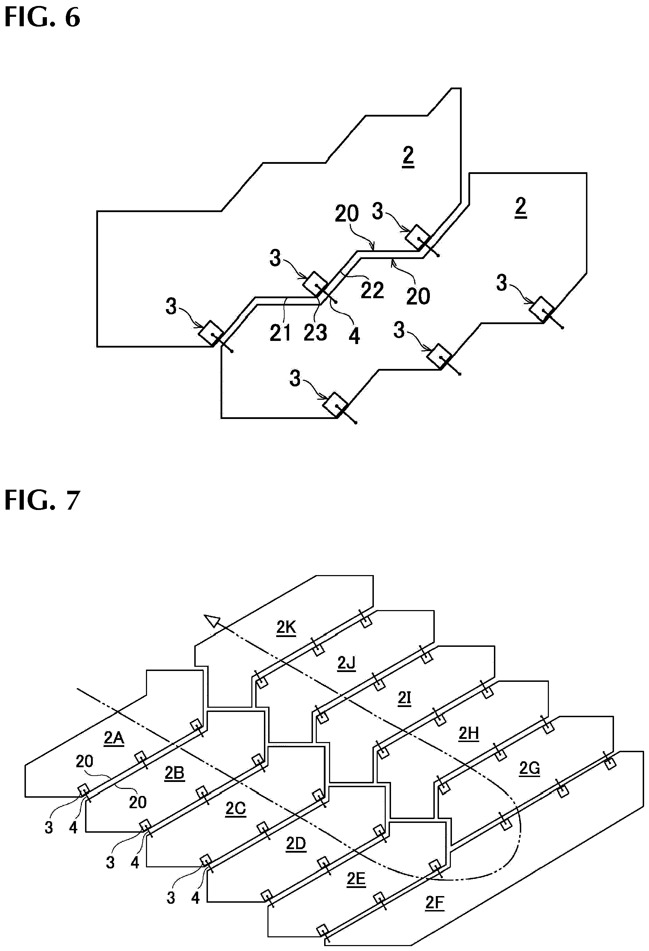

(3) In the ultraviolet light irradiation device 100 according to the above embodiment, the edge 20 of the current-carrying area 2 is formed in a zigzag shape, and includes the plurality of first straight line sections 21, the plurality of second straight line sections 22 extending in a direction intersecting the plurality of first straight line sections 21, and the plurality of bent sections 23 each connecting the first straight line section 21 and the second straight line section 22, the first straight line sections 21 being orthogonal to the second straight line sections 22. However, the zigzag shape is not limited to this; as shown in FIG. 6, the first straight line section 21 may not be orthogonal to the second straight line section 22.

(4) In the above embodiment of the ultraviolet light irradiation device 100, the edge 20 of the current-carrying area 2 is formed in a zigzag shape; however, the edge is not limited to this. As shown in FIG. 7, the edge 20 of the current-carrying area 2 may be formed in a straight line section.

## Claims

1. An ultraviolet light irradiation device (100) comprising:
a substrate (1);
a plurality of current-carrying areas (2) formed on the substrate (1); and
a plurality of ultraviolet light-emitting elements (3) arranged in each of the current-carrying areas (2),
wherein the plurality of current-carrying areas (2) are arranged such that their edges (20) are adjacent each other with an insulation distance apart,
each of the ultraviolet light-emitting elements (3) is arranged on a side of the current-carrying area (2), the side being closer to an adjacent current-carrying area (2) connected to the current-carrying area (2) via a wire,
a first electrode (31) formed on a back surface of each of the ultraviolet light-emitting elements (3) is in contact with the current-carrying area (2), and
a second electrode (32) formed on a front surface of each of the ultraviolet light-emitting elements (3) is connected to the adjacent current-carrying area (2) via the wire.

2. The ultraviolet light irradiation device (100) according to claim 1, wherein each of the edges (20) is formed in a zigzag shape and includes a plurality of first straight line sections (21), a plurality of second straight line sections (22) extending in a direction intersecting the plurality of first straight line sections (21), and a plurality of bent sections (23) each connecting the first straight line section (21) and the second straight line section (22); and
the ultraviolet light-emitting element (3) is disposed such that one side of the ultraviolet light-emitting element (3) is along the first straight line section (21) or the second straight line section (22) of the edge (20).

3. The ultraviolet light irradiation device (100) according to claim 2, wherein the ultraviolet light-emitting element (3) is disposed in the bent section (23) of the edge (20).

4. The ultraviolet light irradiation device (100) according to any one of claims 1 to 3, wherein the plurality of ultraviolet light-emitting elements (3) are presented in a predetermined arrangement pattern and are arranged with approximately equal spacing.

5. The ultraviolet light irradiation device (100) according to claim 4, wherein the plurality of ultraviolet light-emitting elements (3) are presented in a staggered arrangement pattern on the entire substrate (1).

6. The ultraviolet light irradiation device (100) according to any one of claims 1 to 3, wherein the plurality of current-carrying areas (2) are electrically connected to each other in a manner that a power-feeding path meanders.

7. The ultraviolet light irradiation device (100) according to any one of claims 1 to 3, wherein the current-carrying area (2) has its width at least twice as wide as that of the ultraviolet light-emitting element (3).

8. An exposure system comprising:
the ultraviolet light irradiation device (100) according to any one of claims 1 to 3; and
an optical component corresponding to each of the plurality of ultraviolet light-emitting elements (3) arranged in the ultraviolet light irradiation device (100).
